# EUROPEAN PATENT APPLICATION

(11) **EP 0 674 334 A1**
(43) Date of publication of application: **27.09.1995**
(21) Application number: 95103754.8
(22) Date of filing: 15.03.1995
(51) Int. Cl.: H01J 37/32

(54) **Plasma processing method and apparatus**

(30) Priority: 18.03.1994 JP 48287/94
(71) Applicant: HITACHI, LTD., Chiyoda-ku, Tokyo 101 (JP)
(72) Inventor: Watanabe, Seiichi, Yamaguchi-Ken (JP); Furuse, Muneo, Yamaguchi-Ken (JP); Shirayone, Shigeru, Miyagi-Ken (JP); Kaji, Tetsunori, Yamaguchi-Ken (JP)
(74) Representative: Altenburg, Udo, Dipl.-Phys.

(57) **Abstract**

The invention relates generally to plasma processing apparatus and more particularly to a plasma processing apparatus fit for use in subjecting a specimen such as a semiconductor element substrate to etching, filming and the like by means of a microwave plasma. In an embodiment of the invention a space is foreseen between slot antennas (7) for radiating microwaves and a dielectric microwave penetrating window (2) which forms part of a processing chamber (1) and is used for introducing the microwaves into the processing chamber in a plasma processing apparatus using microwaves.

## Description

### BACKGROUND OF THE INVENTION

The present invention relates generally to plasma processing apparatus and more particularly to a plasma processing apparatus fit for use in subjecting a specimen such as a semiconductor element substrate to etching, filming and the like by means of a microwave plasma.

A conventional apparatus of the sort disclosed in U.S. patent No. 4,776,918 and No. 5,134,965, for example, has been arranged so that it is provided with slot antennas which are in contact with or set close to a microwave penetrating window for introducing microwaves into a processing chamber as a part of the processing chamber that can be evacuated.

In the case of the prior art mentioned above, no consideration has been given to the propagation of microwaves radiated from the slot antennas. Since, the slot antennas are arranged in contact with or close to the microwave penetrating window, the length of the propagation path from the slot antennas to a plasma is too short to establish any microwave propagation mode. Therefore, the microwave from the slot antennas is absorbed into a plasma right under the microwave penetrating window immediately without the formation of a microwave mode in its propagation. For this reason, there arises a problem in that since the plasma density right under the slot antennas grows greater, a uniform plasma is hardly formable in the processing chamber.

An object of the present invention is to provide a plasma processing apparatus capable of forming a plasma with greater uniformity.

### SUMMARY OF THE INVENTION

In order to accomplish the object above, a space is provided between slot antennas for radiating microwaves and a microwave penetrating window which forms part of a processing chamber and is used for introducing the microwaves into the processing chamber.

Since the space is provided between the slot antennas and the microwave penetrating window, the microwaves radiated from the slot antennas form a microwave mode in the space after propagating for a fixed distance therein and are then introduced via the microwave penetrating window into the processing chamber that can be evacuated. As the plasma is thus formed by the microwaves having an electromagnetic field in a certain mode in the processing chamber, a more uniform plasma is formed.

### BRIEF DESCRIPTION OF THE DRAWINGS

Figure 1 shows a vertical sectional view of a microwave dry etching apparatus using a magnetic field as a first embodiment of the present invention.

Figure 2 is a top view of the slot antennas of Fig. 1.

Figure 3 is a diagram illustrating a relation between the vertical distance from the quartz window 2 up to the slot antennas 7 and a plasma density.

Figure 4 is a vertical sectional view of a microwave dry etching apparatus using a magnetic field as a second embodiment of the present invention.

Figure 5 is a top view of the mode pass filter of Fig. 4.

Figure 6 is a vertical sectional view of a microwave dry etching apparatus using a magnetic field as a third embodiment of the present invention.

Figure 7 is a top view of the mode pass filter of Fig. 6.

Figure 8 is a vertical sectional view of a microwave dry etching apparatus using a magnetic field as a fourth embodiment of the present invention.

Figure 9 is a vertical sectional view of a microwave dry etching apparatus using a magnetic field as a fifth embodiment of the present invention.

Figure 10 is a vertical sectional view of a microwave dry etching apparatus using a magnetic field as a sixth embodiment of the present invention.

Figure 11 is a vertical sectional view of a microwave dry etching apparatus using a magnetic field as a seventh embodiment of the present invention.

Figure 12 is a vertical sectional view of a microwave dry etching apparatus using a magnetic field as a eighth embodiment of the present invention.

Figure 13 is a vertical sectional view of a microwave dry etching apparatus using a magnetic field as a ninth embodiment of the present invention.

Figure 14 is a vertical sectional view of a microwave dry etching apparatus using a magnetic field as a tenth embodiment of the present invention.

Figure 15 is a vertical sectional view of a microwave dry etching apparatus using a magnetic field as an eleventh embodiment of the present invention.

Figure 16 is a vertical sectional view of a microwave dry etching apparatus using a magnetic field as a twelfth embodiment of the present invention.

Figure 17 is a vertical sectional view of a microwave dry etching apparatus using a magnetic field as a thirteenth embodiment of the present invention.

Figure 18 is a vertical sectional view of a microwave dry etching apparatus using a magnetic field as a fourteenth embodiment of the present invention.

Figure 19 is a vertical sectional view of a vacuum seal portion of a quartz window where microwaves are incident in a microwave dry etching apparatus using a magnetic field as a fifteenth embodiment of the present invention.

Figure 20 is a vertical sectional view of a vacuum seal portion of a quartz window where microwaves are incident in a conventional microwaves dry etching apparatus using a magnetic field.

Figure 21 shows a further embodiment of the invention.

Figure 22 shows the relation between the horizontal distance for the center of the sample stage and the ion current density.
The following reference numerals are used:
- 1: processing chamber,
- 1a: vessel,
- 1b: discharge tube,
- 2: quartz window,
- 3: coil,
- 4: magnetron,
- 5a, 5b: waveguides,
- 6: resonator,
- 7: slot antennas,
- 8: waveguide,
- 9: sample stage,
- 10: workpiece,
- 11: rf generator,
- 12, 13: mode pass filters,
- 14: iris,
- 15: circularly polarized wave generator,
- 16, 17: reentrant resonators,
- 18: resonator,
- 19: hole,
- 20: dielectric,
- 21: quartz window,
- 22: o-ring.

### DETAILED DESCRIPTION OF THE EMBODIMENTS

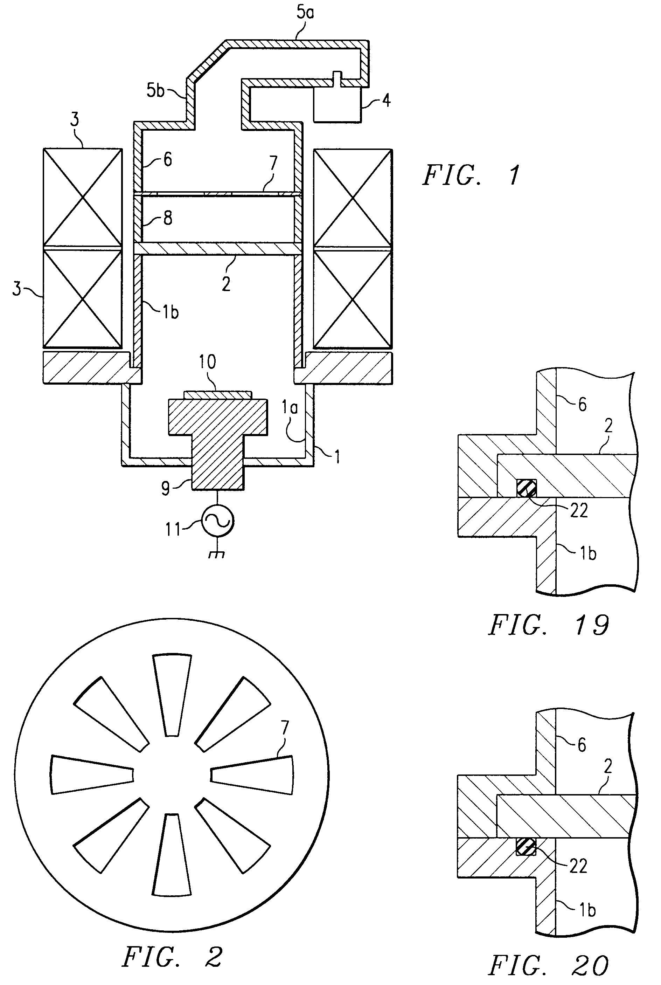

Referring to Figs. 1 through 3 inclusive, an embodiment of the present invention will be described.

Fig. 1 shows a microwave dry etching apparatus using a magnetic field as a first embodiment of a plasma processing apparatus of the present invention. A vacuum exhaust unit (not shown) is first used to evacuate a processing chamber 1 formed with a vessel 1a, a discharge tube 1b and a quartz window 2. Then an etching gas is introduced by a gas supply unit (not shown) into the processing chamber 1 and the pressure therein is regulated as desired. Moreover, the processing chamber 1 is situated in the magnetic field created by coils 3. Microwaves of, in this case, 2.45 GHz oscillated from a magnetron 4 are propagated through waveguides 5a, 5b before being introduced to a resonator 6 and slot antennas 7 are installed in the base of the resonator 6. The microwaves radiated from the slot antennas 7 are propagated through a waveguide 8 and penetrated through the quartz window 2, so that they are introduced into the processing chamber 1 as incident microwaves. The plasma generated by the microwaves is used to process a workpiece 10 placed on a sample stage 9 by etching. In order to control the etching configuration of the workpiece 10, a rf generator 11 is connected via a matching device (not shown) to the sample stage 9 so that radio- frequency voltage may be applicable thereto.

In the present embodiment of the invention, the resonator 6 is configured like a circular TE011 mode resonator and the slot antennas 7 formed in the base of the resonator 6 are radially disposed with respect to the central axis of the resonator as shown in Fig. 2 so as to radiate a circular TE01 mode. In this case, the microwaves radiated respectively from the plurality of slot antennas 7 are propagated through the waveguide 8 having a predetermined length to form microwaves in the circular TE01 mode. In order that the microwaves radiated from the slot antennas 7 may form a specific microwave mode in the whole discharge tube 1b, that is, on a plane therein, a space where the microwaves radiated the slot antennas are caused to diffuse in the specific microwave mode is necessitated between the slot antennas and the quartz window 2 and the waveguide 8 is used to form the space. The resonator 6, the waveguide 8 and the discharge tube 1b are set to have the same inner diameter, so that the microwaves in the circular TE01 mode are allowed to commonly exist. It is advantageous that at least the waveguide 8 and the discharge tube 1b which follow the slot antennas 7 have the same inner diameter: however, their inner diameters may be made different within the range in which the specific mode is formed. The resonator 6 and the slot antennas 7 are effective in generating microwaves in any mode with stability, whereby a stable plasma is effectively generated in the discharge tube 1b. On condition that the resonator 6 and the slot antennas 7 are so configured that the microwaves in the circular TE01 mode may be radiated axisymmetrically, a uniform plasma can effectively be generated by introducing the microwaves in the circular TE01 mode into the discharge tube 1b.

The circular waveguide 5b having the same central axis as that of the resonator 6 is used to introduce microwaves in a circular TE11 mode into the resonator 6. Since the microwave mode in the waveguide is restricted by setting the diameter of the circular waveguide 5b so as to allow only the microwaves in the circular TE11 mode as a basic mode to be propagated therein, further, the fluctuation of the microwave mode and the like which accompany the fluctuation of the plasma is easily suppressed with the effect of stably generating the plasma in cooperation with the resonator 6.

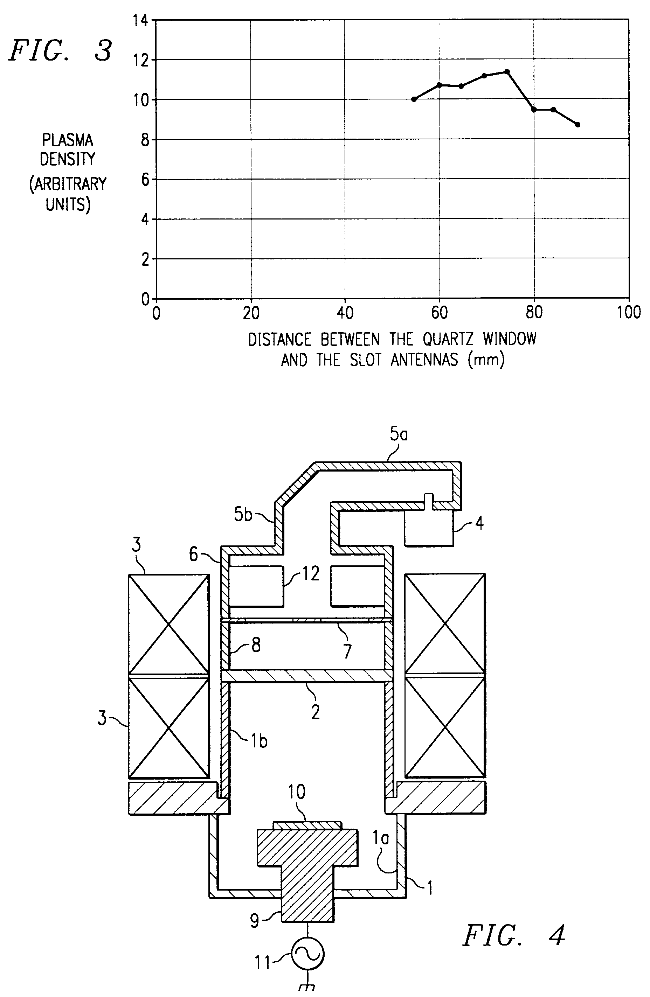

Fig. 3 is a diagram illustrating a relation between the vertical distance from the quartz window 2 up to the slot antennas 7 and a plasma density. In this case, the plasma having the highest density is generated when the distance between the quartz window 2 and the slot antennas 7 is set at 75 mm. In other words, a uniform, high-density plasma can effectively be generated by optimizing the distance between the quartz window 2 and the slot antennas 7.

According to present embodiment of the invention, there is provided the space between the slot antennas 7 and the quartz window 2 for use in introducing the microwaves into the processing chamber 1. Therefore, the microwaves radiated from the slot antennas 7 are totally formed into those in the specific mode which can be introduced into the processing chamber 1 with the effect of making possible the generation of a uniform plasma.

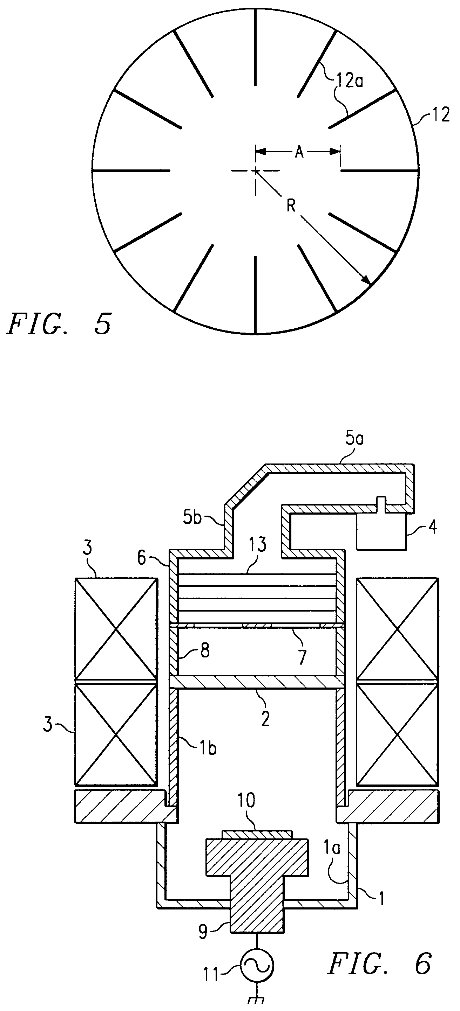

Referring to Figs. 4 and 5, a second embodiment of the present invention will be described, wherein like reference characters designate like members of Fig. 1. In the present embodiment of the invention, a mode pass filter 12 is provided in the resonator 6. With the resonator 6 provided as a resonator in the circular TE01 mode, fins 12a in the form of a conductor plate are radially disposed as shown in Fig. 5 to constitute the mode pass filter 12 in the circular TE01 mode. Fig. 5 is a sectional top view of the resonator 6 in Fig. 4. According to the present embodiment of the invention, the provision of the mode pass filter 12 in the resonator 6 facilitates the formation of a specific microwave mode in the resonator 6 with greater stability. Consequently, the microwaves in the specific mode can be supplied from the slot antennas 7 to the processing chamber 1. Therefore, the fluctuation of the microwave mode and the like which accompany the fluctuation of the plasma is easily suppressed with the effect of stabilizing the plasma.

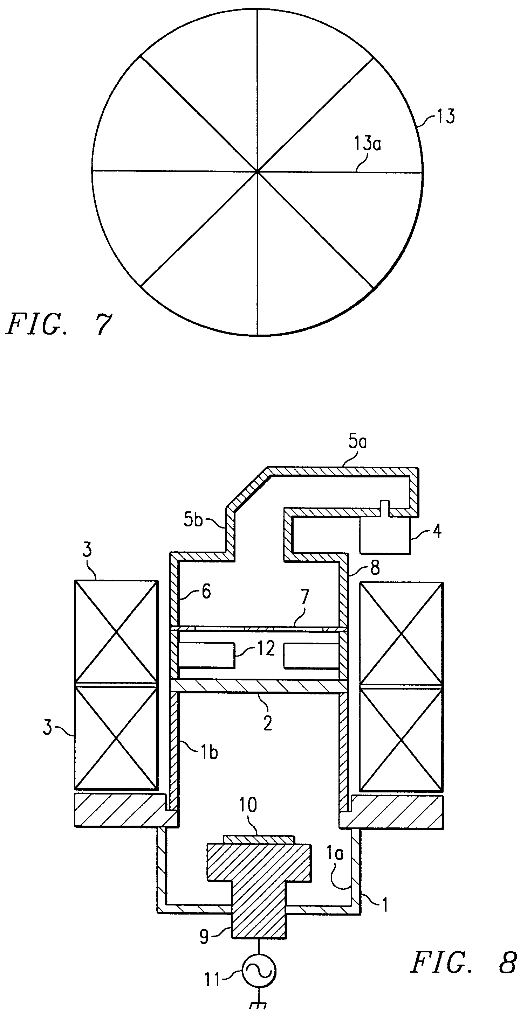

Referring to Figs. 6 and 7, a third embodiment of the present invention will be described, wherein like reference characters designate like members of Fig. 1. In the present embodiment of the invention, a mode pass filter 13 is provided in the resonator 6. As shown in Fig. 7, a plurality of conductor wires 13a are radially disposed to constitute the mode pass filter 13. Fig. 7 is a sectional top view of the resonator 6. The effect of the present embodiment of the invention is that the mode pass filters 13 can readily be manufactured.

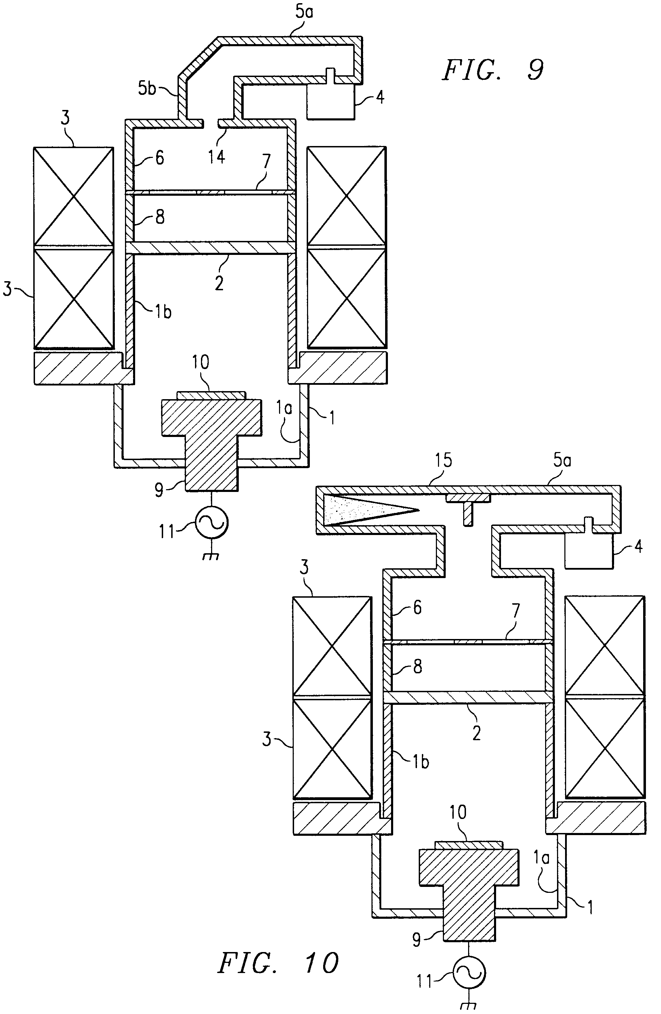

Referring to Fig. 8, a fourth embodiment of the present invention will be described, wherein like reference characters designate like members of Fig. 1. In the present embodiment of the invention, the mode pass filter 12 is provided within the waveguide 8 between the slot antennas 7 and the quartz window 2. According to present embodiment of the invention, the microwaves radiated from the slot antennas 7 are stably formed by the mode pass filter 12 into those in the specific mode which can be introduced into the processing chamber 1 with the effect of making possible the generation of a plasma with greater stability.

Referring to Fig. 9, a fifth embodiment of the present invention will be described, wherein like reference characters designate like members of Fig. 1. In the present embodiment of the invention, an iris 14 formed with a small diameter hole is provided at a port through which the microwaves are introduced to the resonator 6, whereby the resonance characteristic of the resonator 6 is increased with the effect of making possible the generation of a plasma with greater stability.

Referring to Fig. 10, a sixth embodiment of the present invention will be described, wherein like reference characters designate like members of Fig. 1. In the present embodiment of the invention, a circularly polarized wave generator 15 is provided between the magnetron 4 and the resonator 6 so as to introduce microwaves to the resonator 6. Although a turn style circularly polarized wave generator is employed in the present embodiment of the invention, use can also be made of a circularly polarized wave generator which utilizes a dielectric, which is provided with a rod on the sidewall of a waveguide or the like. Circularly polarized microwaves are thus utilized according to the present invention with the effect of facilitating the generation of a more uniform plasma.

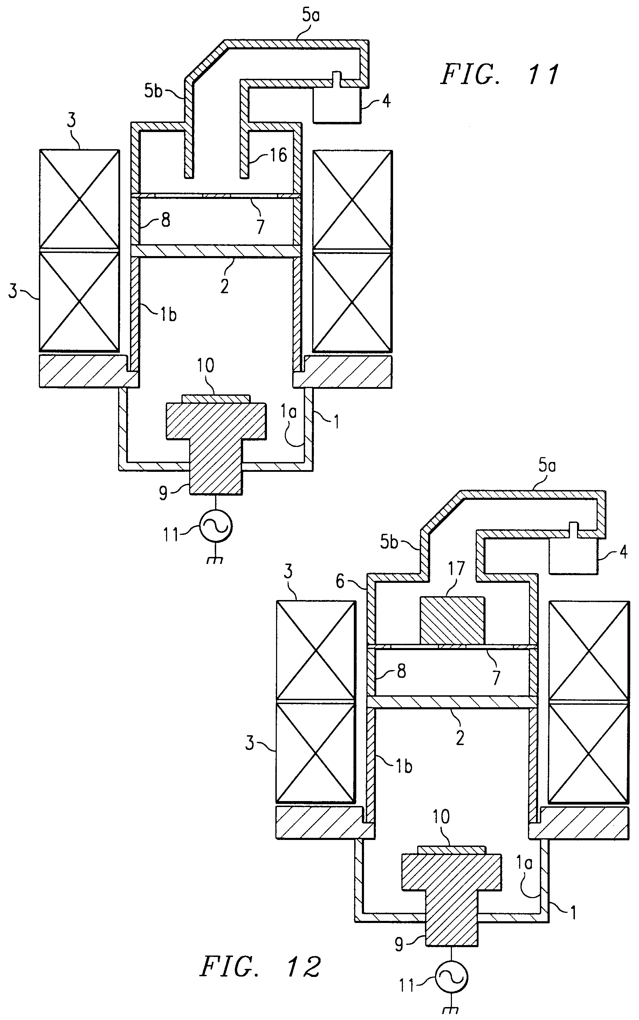

Referring to Figs. 11, 12, a seventh and an eighth embodiment of the present invention will be described, wherein like reference characters designate like members of Fig. 1. In these embodiment of the invention, reentrant resonators 16, 17 are employed with the effect of improving the uniformity of the plasma since microwaves in a mode different from the circular resonator 6 can be radiated from the slot antennas 7.

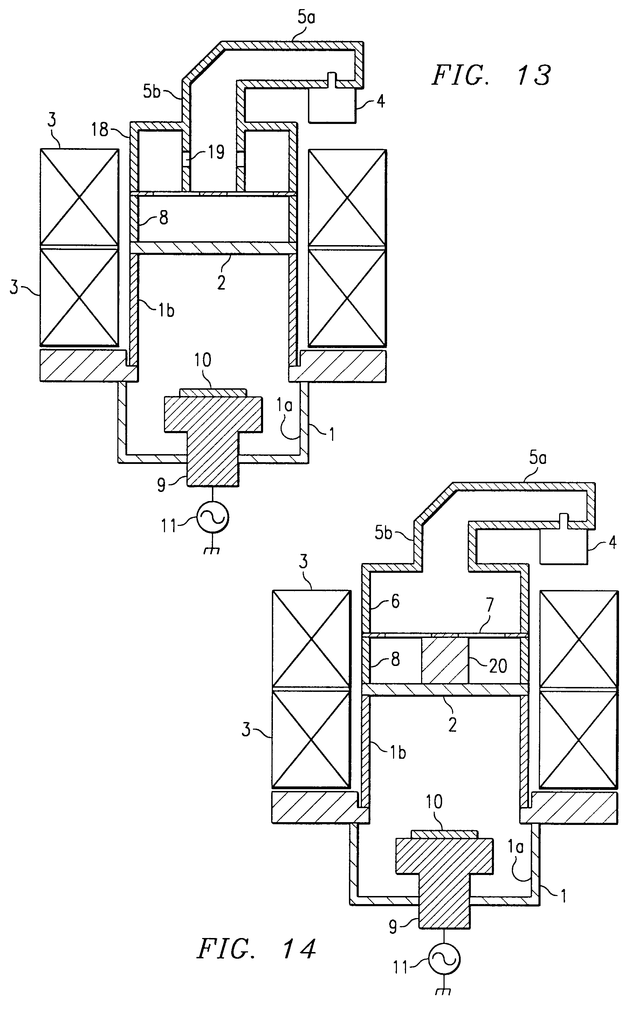

Referring to Fig. 13, a ninth embodiment of the present invention will be described, wherein like reference characters designate like members of Fig. 1. In the present embodiment of the invention, a coaxial resonator 18 is employed with the effect of also improving the uniformity of the plasma since the outer and inner cavities are coupled via small diameter holes 19.

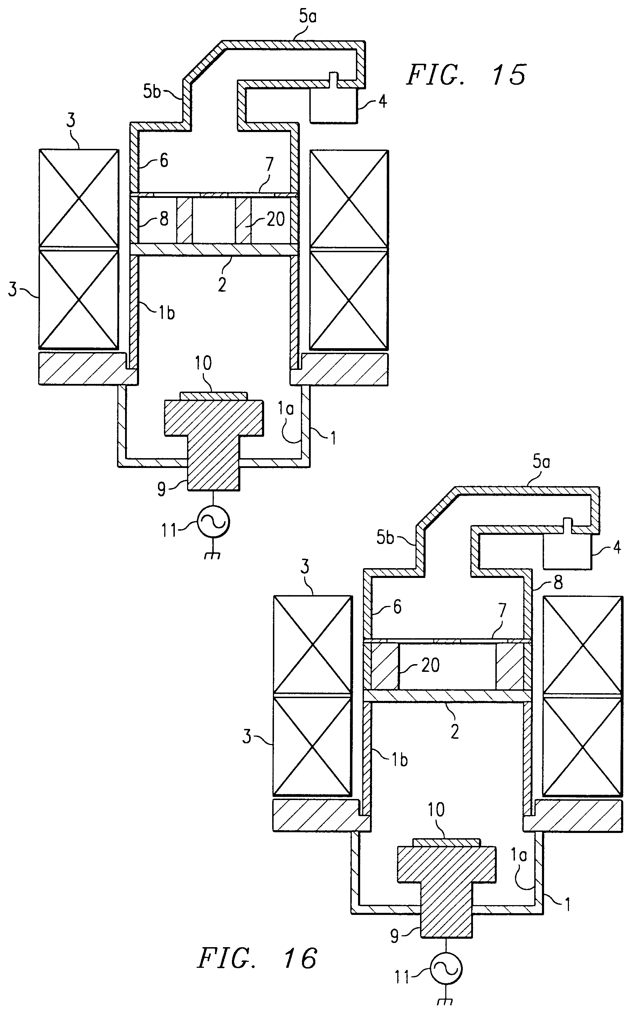

Referring to Figs. 14, 15, 16, a tenth, an eleventh and a twelfth embodiment of the present invention will be described, wherein like reference characters designate like members of Fig. 1. In these embodiments of the invention, a dielectric 20 of such as Teflon, quartz, alumina ceramics or the like is provided in the waveguide 8 in between the slot antennas 7 and the quartz window 2. A columnar dielectric 20 is used in Fig. 14, whereas a cylindrical dielectric 20 is employed in Figs. 15, 16. These embodiments of the invention also have the effect of improving the uniformity of the plasma since the propagation of the microwaves radiated from the slot antennas 7 can be altered by means of these dielectrics 20.

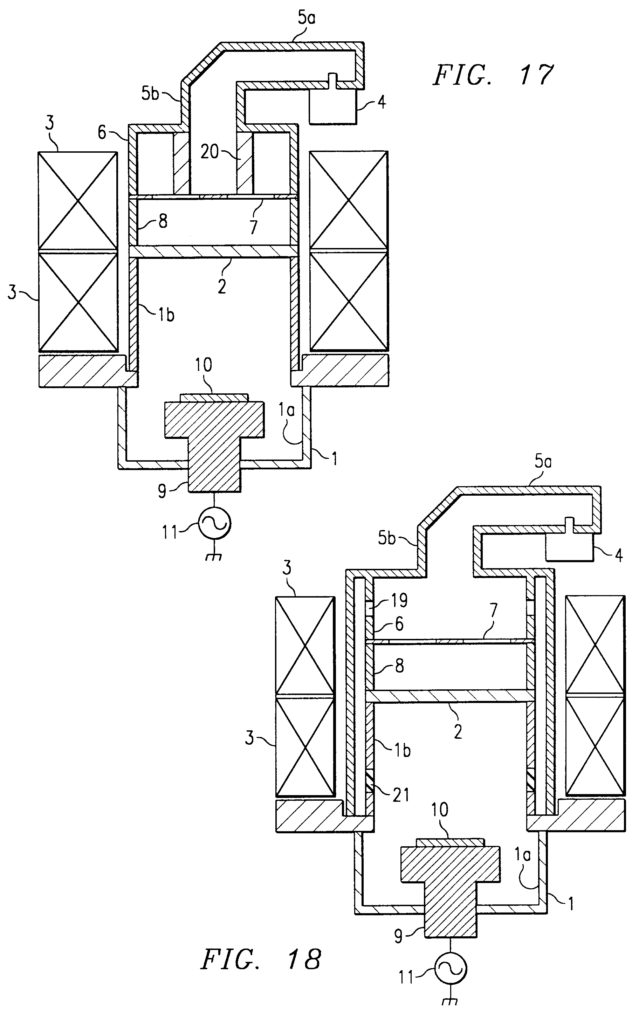

Referring to Fig. 17, a thirteenth embodiment of the present invention will be described, wherein like reference characters designate like members of Fig. 1. In the present embodiment of the invention, the cylindrical dielectric 20 is provided in the resonator 6. The present embodiment of the invention also has the effect of improving the uniformity of the plasma since the resonance mode produced in the resonator 6 can be altered.

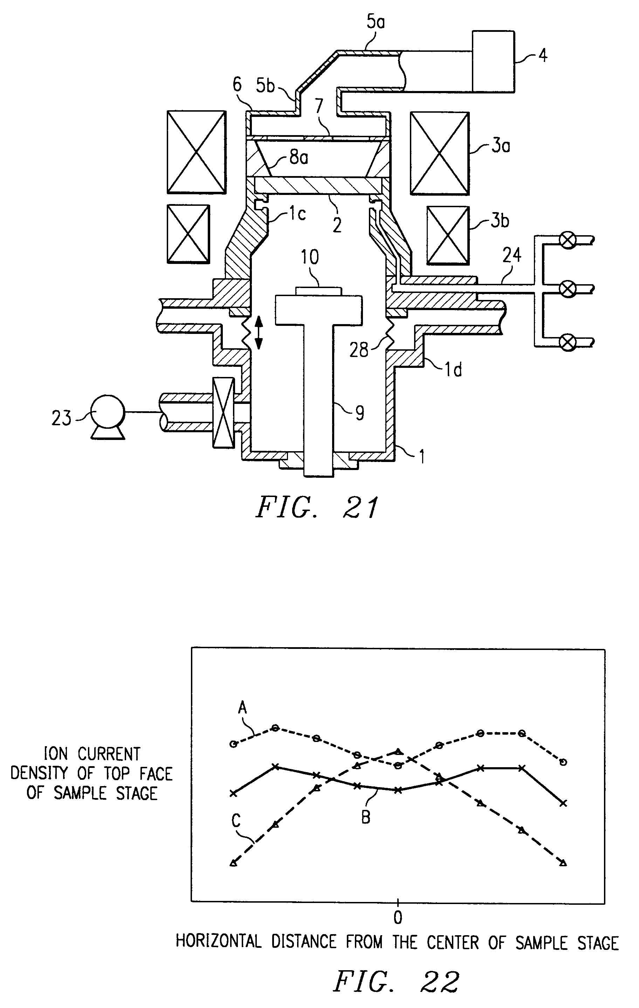

Referring to Fig. 18, a fourteenth embodiment of the present invention will be described, wherein like reference characters designate like members of Fig. 1. In the present embodiment of the invention, the holes 19 are made in the side of the resonator 6 to introduce part of the microwaves to the coaxial outer peripheral portion and then into the processing chamber 1 via a quartz window 21 provided in the sidewall of the discharge tube 1b and at the level between the ECR face and the workpiece 10. Moreover, the microwaves radiated from the slot antennas 7 are also introduced via the quartz window 2 into the processing chamber 1. In this case, the microwaves introduced via the quartz window 2 to the top plate of the processing chamber 1 are not propagated toward the workpiece 10 beyond the ECR face and electrons in the plasma are normally caused to flow along the sidewall of the discharge tube 1b. Since the plasma dies away on the sidewall of the discharge tube 1b, the plasma is distributed in such a way that its density in the central part of the discharge tube 1b is high, whereas the density on the outer periphery is low. In the present embodiment of the invention, the plasma can be generated even on the outer periphery as the sidewall with the effect of improving the uniformity of the plasma since the quartz window 21 is provided at the level between the ECR face through which the microwaves are not allowed to propagate normally and the workpiece 10 so as to introduce part of the microwaves therethrough.

Referring to Figs. 19 and 20, a fifteenth embodiment of the present invention will be described. Fig. 20 illustrates the structure of a vacuum seal portion of a quartz window 2 where microwaves are incident in a conventional processing chamber 1. A groove for an o- ring 22 is formed in the discharge tube 1b as a conductor and the quartz window 2 as a dielectric is flat in shape. On the other hand, Fig. 19 illustrates the structure of a vacuum seal portion of the quartz window 2 in the present embodiment of the invention. A groove for the o-ring 22 is formed on the side of the quartz window 2 as the dielectric and the discharge tube 1b as the dielectric has a flat fitting face. In addition, the o-ring 22 itself is made of dielectric fluoroplastics. Since the propagation of microwaves is greatly affected by the shape of such a dielectric, the surface of the dielectric in the vacuum seal portion is therefore made simple in shape according to the present embodiment of the invention with the effect of having the propagation of microwaves less affected by the vacuum seal portion.

Referring to Figs. 21 and 22, a further embodiment of the present invention will be described. In the present embodiment the waveguide 8 of Fig. 1 is replaced by a reduction wave guide 8a. A discharge tube 1c is enlarged in a cross section toward the sample stage 9. Since the structure like this can provide small discharge area, a coil 3a has a smaller diameter as a main coil to generate an increased magnetic force. Reference numeral 3b designates a coil for controlling magnetic force line. The distribution of the magnetic force line is controlled so as to form the ECR flat face by coil 3b. So, the ECR flat face contributes to a uniform plasma, in a large area in the discharge tube 1c. A vacuum chamber 1d is separated to form the processing chamber 1 by gate valve 28 which is made of cylindrical bellows. When the gate valve 28 has shrinked, the workpiece 10 is transferred into the processing chamber 1. At this time, the sample stage 9 is in a low position to receive the workpiece 10. Reference numeral 23 denotes a vacuum pump; 24 a gas introducing channel.

Fig. 22 is a diagram illustrating a relation between the horizontal distance from the center of the sample stage and the ion current density of 3 types of equipment:
A: with specific wave resonator and reduction wave guide.
B: with specific wave resonator and without reduction wave guide.
C: without specific wave resonator and without reduction wave guide (original style).

In the above examples, the plasma consists of BC*l*3/C*l*2 gasses (used for etching Al).

As shown in Fig. 22, the ion current density of type C equipment (represented by curve C) is chevron shaped (highest point is in the center). Further, the ion current density of the sample stage is not uniform.

The ion current density of type B equipment (represented by curve B) is "M" shaped. The ion current at the center of the sample stage is decreased while the ion current of edge is increased. Therefore, the ion current density at the sample stage is improved. In other words, the wave resonator assists in creating the "M" shaped powerful microwave area. Moreover, used for specific wave resonator and reduction wave guide, the style of ion current density is identical shape. But the whole ion current density is increased. Therefore, the etching rate of Al is faster and more uniform than other systems.

By contrast, in the case of the prior art method, it would be used such a etching system and etching process, especially selectivity of photo resist at the center of wafer, the etching speed of the wafer at the center is faster than the etching speed of the wafer edge, at the thin part of the resist film of the different stage area, so that the shape of photo resist does not keep the original shape.

It would be try to used the specific wave resonator at the part of wave guide, uniformity of ion current density are rise up.

Further, the reduction wave guide could be placed between the wave resonator and quartz window. The uniformity of ion current density is rise up and same shaped. So that the plasma density above the sample stage improved more uniformly and higher density than the normal type of etching equipment. At the result of this method, it is possible to obtain a higher etching rate with uniformity during the etching process of the wafer.

Although a description has been given of the microwave dry etching apparatus using a magnetic field in each embodiment of the present invention, effects similar to those stated above are achievable likewise by plasma processing apparatus such as dry etching apparatus using microwaves, plasma CVD apparatus, etching apparatus and the like.

According to the present invention, the space provided between the slot antennas for radiating microwaves and the dielectric microwave penetrating window which forms a part of the processing chamber and is used for introducing the microwaves into the processing chamber allows the microwaves in the specific mode to be introduced into the processing chamber with the effect of greatly improving the uniformity of a plasma to be generated.

## Claims

1. A plasma processing apparatus comprising:
a microwave source (4), connected to a waveguide (5);
a planar antenna (7) receiving microwave transmission from said source (4) and having a microwave source side and a workpiece side; and
a dielectric microwave penetrating window (2) located on said workpiece side of said planar antenna (7) and on one side of a plasma processing chamber (1) at a distance from said planar antenna (7).

2. An apparatus as in claim 1 further comprising a mode pass filter (12, 13) located on said microwave source side of said planar antenna (7).

3. An apparatus as in claim 1 further comprising a mode pass filter (12, 13) located on said workpiece side of said planar antenna (7).

4. An apparatus according to one of the preceding claims further comprising an iris (14) located between said planar antenna (7) and said microwave source.

5. An apparatus according to one of the preceding claims wherein said microwave source comprises a circularly polarized wave generator (15)

6. An apparatus according to one of the preceding claims further comprising a reentrant resonator (16, 17) located on said microwave source side of said planar antenna (7).

7. An apparatus as in claim 6 wherein said reentrant resonator is in contact with said planar antenna (7).

8. An apparatus as in claim 6 wherein said reentrant resonator is not in contact with said planar antenna (7).

9. An apparatus according to one of the preceding claims further comprising a resonating member between said waveguide (5) and said planar antenna (7).

10. An apparatus according to one of the preceding claims further comprising a coaxial resonator (18) in electromagnetic communication with a resonator (6) through an aperture (19).

11. An apparatus according to one of the preceding claims further comprising a dielectric (20) located between said planar antenna (7) and said dielectric microwave penetrating window (2) wherein said dielectric has a cross-sectional area less than that of said window.

12. An apparatus as in claim 11 wherein said dielectric (20) is in contact with said window.

13. An apparatus as in claim 11 wherein said dielectric (20) is not in contact with said planar antenna (7).

14. An apparatus according to one of the preceding claims further comprising a dielectric (20) located in a resonator (6) concentric with said planar antenna (7).

15. An apparatus as in claim 14 wherein said dielectric is in contact with said planar antenna (7).

16. An apparatus according to one of the preceding claims further comprising an outer peripheral portion which is:
positioned coaxially with a resonator (6) and said chamber, in electromagnetic communication with said resonator through apertures (19), and
in electromagnetic communication with said chamber through apertures (21).

17. An apparatus as in claim 9 wherein said resonating member has a smaller diameter in the area of the window that in the area of the planar antenna (7).

18. An apparatus according to one of the preceding claims further comprising a coil (3) around said plasma chamber for forming ECR plasma below said window.

19. An apparatus according to one of the preceding claims wherein said planar antenna comprises multiple apertures and said multiple apertures comprise slots.

20. An apparatus according to one of the preceding claims wherein said distance is between about 55mm and about 90 mm.

21. An apparatus according to one of the preceding claims wherein said distance is between about 60mm and about 80 mm.

22. An apparatus according to one of the preceding claims wherein said distance is between about 70mm and about 75mm.

23. An apparatus according to one of the preceding claims wherein a space between said planar antenna (7) and said window is at least partially filled with a dielectric.

24. An apparatus as in claim 1 further comprising a reduction wave guide (26) between said planar antenna and said window.

25. An apparatus as m claim 24 further comprising a specific wave resonator (24).

26. An apparatus according to one of the proceeding claims wherein a space between said planar antenna (7) and said window includes no dielectric.

27. A plasma processing method comprising:
transmitting microwave energy to a planar antenna (7);
generating a specific mode of microwave energy between the planar antenna (7) and a microwave transmitting window;
containing a plasma generating substance in a plasma processing chamber;
passing the specific mode through the microwave transmitting window into the plasma processing chamber; and
treating a workpiece located on a sample stage by using said plasma.

28. A plasma generating method comprising:
transmitting microwave energy to a planar antenna (7);
generating a specific mode of microwave energy between the planar antenna (7) and a microwave transmitting window;
containing a plasma generating substance in a plasma processing chamber; and
passing the specific mode through the microwave transmitting window into the plasma processing chamber.

29. A method as in claim 28 further comprising resonating a standing wave of microwave energy in a resonating chamber, said resonating chamber being defined between a waveguide and a planar antenna (7), said planar antenna (7) being spaced from the microwave transmitting window.

30. A method as in claim 29 further comprising filtering the mode of the microwave energy.

31. A method as in claim 30 wherein said filtering occurs between said planar antenna (7) and said waveguide.

32. A method as in claim 30 wherein said filtering occurs between said planar antenna (7) and said window.
